# NEUE EUROPÄISCHE PATENTSCHRIFT

(11) **EP 2 670 797 B2**
(45) Veröffentlichungstag und Bekanntmachung des Hinweises auf die Entscheidung über den Einspruch: **12.09.2018**
(45) Hinweis auf die Patenterteilung: 18.03.2015
(21) Anmeldenummer: 12702801.7
(22) Anmeldetag: 31.01.2012
(51) Int. Cl.: C08K 5/00, C08K 5/14, C08L 23/08

(54) **PEROXIDABMISCHUNGEN FÜR DIE BESCHLEUNIGTE VERNETZUNG VON ETHYLENVINYLACETAT**
PEROXIDE MIXTURES FOR THE ACCELERATED CURE OF ETHYLENE-VINYL ACETATE
COMPOSITIONS DE PEROXYDE POUR LA RÉTICULATION ACCÉLERÉÉ DE L'ÉTHYLÈNE-ACÉTATE DE VINYLE

(30) Priorität: 31.01.2011 DE 102011003382
(43) Veröffentlichungstag der Anmeldung: 11.12.2013
(73) Patentinhaber: United Initiators GmbH, 82049 Pullach (DE)
(72) Erfinder: KUNZ, Martin, 82544 Dettenhausen (DE); SEITZ, Katharina, 80992 München (DE); NAGL, Iris, 81377 München (DE)
(74) Vertreter: Weickmann & Weickmann PartmbB
(86) Internationale Anmeldenummer: PCT/EP2012/051555
(87) Internationale Veröffentlichungsnummer: WO 2012/104298

(56) Entgegenhaltungen:
- EP-A1- 1 857 500
- EP-A2- 0 259 537
- EP-A2- 0 314 132
- EP-A2- 2 371 898
- WO-A1-2010/029468
- WO-A2-2010/074394
- CN-A- 1 176 974
- CN-A- 101 575 274
- CN-A- 101 870 854
- DE-A1- 2 130 273
- JP-A- H0 551 404
- JP-A- H0 570 676
- JP-A- H02 284 905
- JP-A- H04 126 726
- JP-A- H09 227 611
- JP-A- S55 165 910
- JP-A- S57 164 106
- JP-A- S60 243 114
- JP-A- 2002 069 114
- JP-A- 2004 002 518
- JP-A- 2004 300 243
- JP-A- 2005 054 052
- JP-A- 2006 111 862
- KR-A1- 20090 030 729
- US-A- 5 589 526
- US-B1- 4 278 558
- US-B1- 4 952 652
- US-B1- 6 124 409

## Beschreibung

Die vorliegende Erfindung betrifft Peroxidgemische und insbesondere Peroxidgemische, die für eine beschleunigte Vernetzung von Ethylenvinylacetat geeignet sind.

In der peroxidischen Vernetzung von Polymeren, wie z.B. Polyolefinen (LDPE, HDPE, LLDPE) oder Elastomeren (EVA, EPDM, NBR, BR, SBR), werden thermisch stabile Peroxide eingesetzt, die es erlauben mit Mischaggregaten wie Knetwerken und Extrudern Compounds herzustellen, ohne dass eine Vorvernetzung während des Compoundierprozesses eintritt. Die fertigen Mischungen werden dann in Granulat-oder Pulverform den verarbeitenden Maschinen wie z.B. Extrusionsanlagen (zur Herstellung von Schläuchen, Profilen, Folien) zugeführt. Diese Maschinen können bereits eine Folgeeinrichtung zur Vernetzung besitzen, z.B. Öfen, Salzbäder oder Autoklaven, in denen das Profil bei erhöhter Temperatur vernetzt wird. Hierzu muß die Zerfallstemperatur des Peroxids zwangsläufig deutlich überschritten werden. Die gängige Praxis weist auf Peroxide hin, die für den Compoundierprozeß ausreichend thermisch stabil sind und auch bei Raumtemperatur lagerbar und transportierbar sind.

Problematisch bei den bisher eingesetzten Peroxiden war, dass sie einerseits ausreichend stabil sein müssen, um nicht ein vorzeitiges Vernetzen des Polymers noch im Granulatzustand oder bei der Formgebung, z.B. beim Extrudieren, zu bewirken. Andererseits sollten die Peroxide dann zum gewünschten Zeitpunkt bei möglichst geringen Temperaturen und hoher Geschwindigkeit eine Vernetzung der Polymere bewirken.

Es wurde nun gefunden, dass mit speziellen Peroxidgemischen genau diese Anforderungen erfüllt werden können. Die Erfindung betrifft deshalb ein Peroxidgemisch, umfassend eine Kombination von
(i) Tert-butyl-peroxy-2-ethylhexanoat (TBPEH) und
(ii) Tert-butylperoxy (2-ethylhexyl) carbonat (TBPEHC),
wobei TBPEH in einer Menge von 5 bis 15 Gew.% und TBPEHC in einer Menge von 85 bis 95 Gew.% bezogen auf die Gesamtperoxidmischung vorliegt.

Es wurde festgestellt, dass die erfindungsgemäßen Peroxidgemische stabil sind und somit bei Temperaturen bis zu 50 °C und insbesondere bei Raumtemperatur lagerbar und transportierbar sind. Sie können auch mit vernetzbaren Polymeren vermischt und verarbeitet werden, beispielsweise in einem Compoundierprozess oder in einem Extrusionsprozess, ohne dass eine vorzeitige Vernetzung eintritt. Andererseits wird mit den erfindungsgemäßen Peroxidgemischen bereits bei relativ niedrigen Vernetzungstemperaturen, z.B. bei 120 °C bis 150 °C, eine hohe Vernetzungsgeschwindigkeit und eine hohe Effizienz im Vernetzungsgrad erreicht.

Ein wesentlicher Bestandteil des erfindungsgemäßen Peroxidgemisches ist ein Peroxyester TBPEH.

Der Peroxyester wird in dem erfindungsgemäßen Peroxidgemisch als vernetzungsbeschleunigend wirkendes organisches Peroxid eingesetzt. Erfindungsgemäß umfasst die Komponente (i) Tert-butyl-per-2-ethylhexanoat (TBPEH):

### Peroxyester:

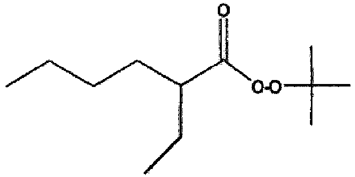

Besonders günstige Gemische werden erhalten, wenn die Komponente (i) TBPEH umfasst.

Der Anteil an Komponente (i) im Peroxidgemisch beträgt 5 bis 15 Gew.-%, jeweils bezogen auf das Gesamtgewicht an Peroxiden im Peroxidgemisch.

Neben dem vernetzungsbeschleunigend wirkenden Peroxyester als Komponente (i) umfassen die erfindungsgemäßen Peroxidgemische als Komponente (ii) wenigstens ein weiteres von der Komponente (i) unterschiedliches Peroxid. Die Komponente (ii) umfasst das Monoperoxycarbonat Tert-butylperoxy(2-ethylhexyl)-carbonat (TBPEHC).

Monoperoxycarbonate:

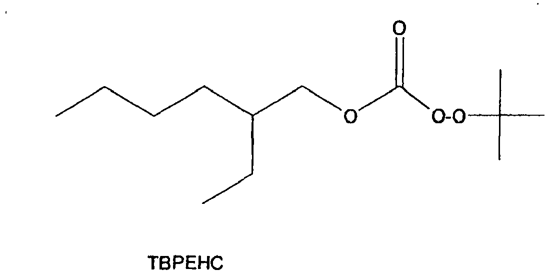

Der Anteil an Komponente (ii) im Peroxidgemisch beträgt 85 bis 95 Gew.-%.

Erfindungsgemäß ist ein Peroxidgemisch umfassend eine Kombination von Tert-butyl-per-2-ethylhexanoat (TBPEH) und Tert-butyl(2-ethylhexanoat)carbonat (TBPEHC).

Erfindungsgemäß ist eine Mischung umfassend 5 bis 15 Gew.-% TBPEH und 85 bis 95 Gew.-% TBPEHC. Am meisten bevorzugt sind Mischungen umfassend 8 bis 12 Gew.-% TBPEH und 88 bis 92 Gew.-% TBPEHC. Solche Gemische können z.B. bei Raumtemperatur transportiert und gelagert werden im Gegensatz zu technischem reinen TBPEH.

Die Anspringtemperaturen der erfindungsgemäßen Gemische liegen vorzugsweise wenigstens 10 °C, mehr bevorzugt wenigstens 15 °C und noch mehr bevorzugt wenigstens 20 °C höher als die Anspringtemperaturen des Peroxids der Komponente (i) alleine.

So wird beispielsweise die Anspringtemperatur von reinem TBPEH, die bei ca. 60 °C liegt, in einem Gemisch aus 15 Gew.-% TBPEH und 85 Gew.-% TBPEHC auf ca. 80 °C erhöht.

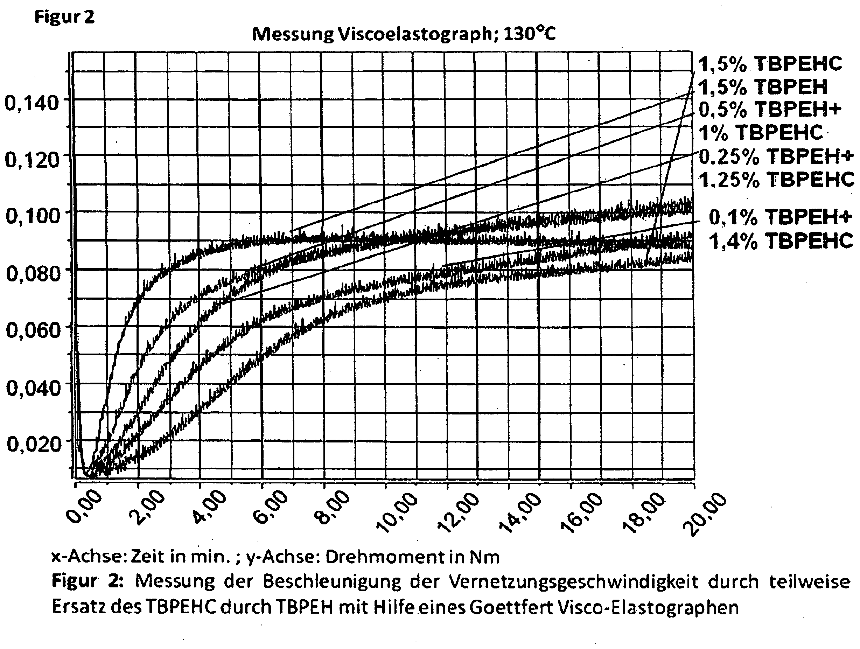

Weiterhin kann mit den erfindungsgemäßen Gemisch eine Beschleunigung der Vernetzung von Polymeren gegenüber einer Verwendung von Peroxiden der Komponente (ii) erhalten werden. Eine deutliche Beschleunigung der Vernetzungsreaktion bei Verwendung von Gemischen aus TBPEH und TBPEHC im Vergleich zu reinem TBPEHC ist beispielsweise in Figur 2 gezeigt. Zudem kann mit den erfindungsgemäßen Gemischen eine Erhöhung der Vernetzungsdichte (also des Vernetzungsgrades) im Vergleich zur Verwendung von den reinen Komponenten (i) oder (ii) erhalten werden.

Die erfindungsgemäßen Gemische und insbesondere ein Gemisch aus TBPEH und TBPEHC vereinen somit die vorteilhaften Eigenschaften der Einzelkomponenten, wobei gleichzeitig die Nachteile der Einzelkomponenten (also beispielsweise vorzeitige Vernetzung durch die beschleunigend wirkende Komponente bzw. lange Reaktionszeit der Komponente (ii)) vermieden werden.

Bei den Komponenten (i) und (ii) des erfindungsgemäßen Peroxidgemisches handelt es sich um organische Peroxide. Peroxide der Komponenten (i) und/oder (ii) können bevorzugt flüssig, pastös oder als Feststoff vorliegen.

Das Mischungsverhältnis der Peroxidkomponenten kann nach gewünschten Vernetzungsgeschwindigkeiten variiert werden. Jede der Komponenten (i) und (ii) wird vorzugsweise in einer Menge von mindestens 1 Gew.-%, mehr bevorzugt mindestens 5 Gew.-% und bis zu 99 Gew.-%, vorzugsweise bis zu 95 Gew.-%, bezogen auf das Gesamtgewicht an Peroxiden im Peroxidgemisch, eingesetzt. In einer bevorzugten Ausführungsform ist der Peroxyester als Komponente (i) in einer Menge von 5 Gew.-% bis 15 Gew.-% enthalten und das Peroxid der Komponente (ii) in einem Anteil von 85 bis 95 Gew.-%.

Die Peroxidgemische können auch weitere Hilfsstoffe wie z.B. Verdünnungsmittel umfassen, beispielsweise Phlegmatisierungsmittel. Bevorzugt umfasst das erfindungsgemäße Peroxidgemisch Coagentien, beispielsweise Triallylcyanurat, Trallylisocyanurat oder ähnliches, oder ungesättigte Acrylate, insbesondere dimere oder trimere ungesättigte Acrylate. Weiterhin können Antioxidantien, insbesondere phenolische Antioxidantien wie z.B. Pentaerythritol oder Tetrakis(3-(3,5-di-tert-butyl-4-hydroxyphenyl)propionat), enthalten. Peroxidgemische können auch Haftvermittler, insbesondere Silane wie z.B. Vinyltrimethoxysilan (VTMO) enthalten. Den erfindungsgemäßen Peroxidgemischen können auch weitere Verdünnungsmittel oder Zusatzstoffe, insbesondere im Hinblick auf die jeweils beabsichtigte Anwendung, zugegeben werden.

Das erfindungsgemäße Peroxidgemisch eignet sich insbesondere zur Vernetzung von Polymeren. Bevorzugt werden Polymere wie Polyolefine, insbesondere Polyethylen oder Polypropylen und noch mehr bevorzugt Polyethylen geringer Dichte (LDPE), Polyethylen hoher Dichte (HDPE) oder lineares Polyethylen geringer Dichte (LLDPE) vernetzt. Weiterhin eignet sich das Peroxidgemisch auch zur Vernetzung von Elastomeren, wie z.B. Ethylenvinylacetat (EVA), Ethylen-Propylen-Dien-Kautschuk (EPDM), Nitril-Butadien-Kautschuk (NBR), Butadien-Kautschuk (BR) oder Styrol-Butadien-Kautschuk (SBR). Besonders bevorzugt ist die Verwendung des erfindungsgemäßen Peroxidgemisches zur Vernetzung von Ethylenvinylacetat.

Erfindungsgemäß können Homopolymere, gebildet aus einem einzigen Monomer, oder Copolymere, gebildet aus zwei oder mehreren unterschiedlichen Monomeren, vernetzt werden. Besonders bevorzugt handelt es sich bei dem zu vernetzenden Polymer um ein Ethylenvinylacetat-Copolymer, umfassend einen Anteil an Ethylen, insbesondere einen Ethylen-Anteil von 40 bis 90 Gew.-%, mehr bevorzugt von 60 bis 85 Gew.-% und noch mehr bevorzugt von 65 bis 70 Gew.-%, sowie einen Anteil an Vinylacetat, insbesondere einen Vinylacetat-Anteil von 10 bis 60 Gew.-%, mehr bevorzugt von 15 bis 40 Gew.-% und noch mehr bevorzugt von 30 bis 35 Gew.-%, jeweils bezogen auf das Gesamtgewicht des EVA-Polymers. Solche Ethylenvinylacetat-Vinylacetatcopolymere weisen insbesondere eine hohe Witterungsbeständigkeit, eine hohe Transparenz und eine hervorragende Lichttransmission auf.

Ein bevorzugt eingesetztes Ethylenvinylacetatpolymer ist beispielsweise Elvax PV1400Z von DuPont.

Aufgrund der Eigenschaften der erfindungsgemäßen Peroxidmischung kann die Vernetzung der Polymere und insbesondere die Vernetzung von Ethylenvinylacetat bei relativ geringen Temperaturen durchgeführt werden, insbesondere bei einer Temperatur im Bereich von 80 bis 150 °C, bevorzugt im Bereich von 120 bis 150 °C und noch mehr bevorzugt im Bereich von 125 bis 140°C.

Ein besonders bevorzugtes Anwendungsgebiet des erfindungsgemäßen Peroxidgemisches ist die Vernetzung von Ethylenvinylacetatfolien bei der Einkapselung von Silicium-Wafern bei der Solarzellenherstellung. Die zur Folienherstellung vorgefertigten Compounds können neben Peroxiden zusätzlich weitere Stoffe, wie Silane, Coagentien und verschiedene Stabilisatoren enthalten. Die Herstelltemperatur der Compounds z.B. im Extruder hängt vom Erweichungspunkt des verwendeten EVA-typs ab. Bislang wurden nur Peroxide mit deutlich höherer Stabilität als der Erweichungspunkt des EVA verwendet, um Vorvernetzungsprobleme zu vermeiden, aber auch einen Transport bei Umgebungstemperatur zu ermöglichen. Aus diesen Granulaten werden dann Folien als Halbzeug extrudiert und in sogenannten Vakuum-Laminatoren bei Temperaturen von ca. 150 bis 180°C zur Ummantelung von Silicium-Wafern einerseits und deren Verklebung mit der Verglasung auf Front und Rückseite andererseits verwendet. Besondere Anforderungen an das Einkapselungsmaterial betreffen: Lichttransmission, Hydrolysebeständigkeit, keine Blasenbildung, keine Vergilbungsneigung sowie Kriechfestigkeit unter Belastung und Temperatur.

Die vorliegende Erfindung ermöglicht dem Endanwender aufgrund optimierter ausgewählter Peroxidkombinationen seine Vakuumlaminationszeit deutlich herabzusetzen oder die Vernetzungstemperatur zu senken. Die hierfür entwickelten erfindungsgemäßen Peroxidmischungen weisen bei erheblich höherer Vernetzungsgeschwindigkeit zusätzlich eine höhere Effizienz im Vernetzungsgrad auf, somit sind zusätzlich geringere Peroxiddosierungen möglich. Die Verarbeitungssicherheit bei der Folienherstellung ist trotzdem gewährleistet. Es konnte keine Vorvernetzung festgestellt werden.

Weiterhin lassen sich Mischungen, vorzugsweise mit 10% TBPEH und 90% TBPEHC, noch bei Umgebungstemperatur transportieren.

Eine typische Vorgehensweise zur Herstellung von vernetzten, geformten Polymeren ist wie folgt:
Zunächst wird eine Vormischung bereitgestellt, welche ein vernetzbares Polymer sowie ein erfindungsgemäßes Peroxidgemisch umfasst. Dabei kann das erfindungsgemäße Peroxidgemisch in flüssiger, gelöster, suspendierter oder fester Form einem Polymer, insbesondere Ethylenvinylacetat, zugesetzt werden. Die Vormischung wird vorzugsweise in Mischaggregaten zu Compounds verarbeitet, in denen die Bestandteile homogen vermischt vorliegen. Geeignete Mischaggregate sind beispielsweise Knetwerke oder Extruder. Wichtig ist hierbei, dass keine Vorvernetzung während des Compoundiervorgangs eintritt.

Noch mehr bevorzugt ist, dass zunächst ein Masterbatch gebildet wird, umfassend ein erfindungsgemäßes Peroxidgemisch und ein vernetzbares Polymer, wobei das Peroxidgemisch in relativ hoher Konzentration, beispielsweise von 0,5 Gew.-% bis 75 Gew.-%, mehr bevorzugt von 10 Gew.-% bis 50 Gew.-%, bezogen auf das Gesamtgewicht des Masterbatches vorliegt. Zur Masterbatchherstellung können einfache Mischer, wie beispielsweise Schaufelmischer oder Taumelmischer, oder Compoundierungsanlagen, wie beispielsweise Extruder, insbesondere Zweischneckenextruder oder Knetwerke verwendet werden. Durch Zugabe des Masterbatches zu weiterem Polymer, insbesondere in Pulver- oder Granulatform, kann dann eine für die Formgebung geeignete Vormischung gebildet werden.

Dem Masterbatch oder/und der Vormischung können auch weitere Additive zugegeben werden, wie beispielsweise Stabilisatoren, Haftvermittler, Coagentien etc. Besonders geeignet sind Coagentien wie Triallylcyanurat, Triallylisocyanurat oder dimere oder trimere ungesättigte Acrylate, Antioxidantien, insbesondere phenolische Antioxidantien wie z.B. Pentaerythritol, Tetrakis(3-3,5-di-tert-butyl-4-hydroxyphenyl)propionat, oder Haftvermittler, insbesondere Silane wie z.B. Vinyltrimethoxysilan (VTMO).

Die Zugabe des erfindungsgemäßen Peroxidgemisches zu dem Polymer, insbesondere zu Ethylenvinylacetat, kann als bereits vorgemischtes Peroxidgemisch oder in Form der einzelnen Komponenten erfolgen. Vorzugsweise erfolgt die Zugabe von einzelnen Peroxiden oder als bereits vorgemischtem Peroxidgemisch in einfachen Mischern, wie beispielsweise Schaufelmischern oder Taumelmischern, oder in anderen Compoundierungsanlagen, wie beispielsweise Zweischneckenextrudern oder Knetwerken. Die Vormischungen umfassend das erfindungsgemäße Peroxid und ein vernetzbares Polymer, insbesondere vernetzbares Ethylenvinylacetat, werden vorzugsweise in Granulat- oder Pulverform gebildet. Diese Compounds können dann einer formgebenden Maschine, wie z.B. einer Folienextrusionsanlage, zugeführt werden. Bevorzugt beträgt die Peroxidkonzentration in solchen Vormischungen 0,1 bis 5 Gew.-% Peroxid bezogen auf das Gewicht des zu vernetzenden Polymers.

Es ist aber auch möglich, zunächst nicht Vormischungen zu bilden, sondern die einzelnen Peroxide oder das erfindungsgemäße Peroxidgemisch direkt beim Formgebungsverfahren zuzugeben. Die Peroxide können beispielsweise über verschiedene Dosiereinrichtungen, wie Injektion, in den Extrudierzylinder oder Dosierung in die Einzugszone beim Extrudieren zugegeben werden.

Neben den Peroxiden können weitere Additive, wie z.B. Coagentien, insbesondere Triallyl(iso)cyanurat, Antioxidantien, insbesondere phenolische Antioxidantien, Stabilisatoren, insbesondere UV-Stabilisatoren oder/und Silan zugegeben werden.

Die Erfindung betrifft deshalb weiterhin ein Verfahren zur Herstellung eines vernetzten Polymers, insbesondere eines Ethylenvinylacetats, umfassend
(i) Vermischen eines erfindungsgemäßen Peroxidgemisches mit einem vernetzbaren Polymer, insbesondere mit einem vernetzbaren Ethylvinylacetat,
(ii) Formen des Gemisches aus vernetzbarem Polymer und Peroxiden und
(iii) Erhöhen der Temperatur des Gemisches, um eine Vernetzung des geformten Polymers zu bewirken.

Bei dem erfindungsgemäß zu vernetzenden Ethylvinylacetat handelt es sich vorzugsweise um ein Ethylvinylacetat mit einem Anteil an einpolymerisiertem Vinylacetat von > 15 %.

In Schritt (ii) wird das Gemisch aus vernetzbarem Polymer und Peroxiden einem formgebenden Verfahren unterzogen, wie beispielsweise Extrusion zur Bildung von Folien, Schläuchen oder Dichtungen, einem Spritzpress- oder/und einem Spritzgußverfahren. In einem anschließenden Schritt kann dann das Polymer im geformten Gegenstand durch Erhöhung der Temperatur des Gemisches, insbesondere auf einen Bereich von 120 bis 150 °C, vernetzt werden.

In einer besonders bevorzugten Ausführungsform dient das erfindungsgemäße Verfahren zur Vernetzung von Ethylenvinylacetatfolien, insbesondere bei der Einkapselung von Solarzellen-Wafern im Vakuumlaminationsprozess. Durch die Beschleunigung der Vernetzung durch den Zusatz eines Peroxyesters gemäß Komponente (i) des erfindungsgemäßen Peroxidgemisches können Zykluszeiten im Vakuumlaminationsprozess erheblich verkürzt werden bzw. die üblichen Vernetzungstemperaturen, je nach verwendeter Peroxidmischung deutlich herabgesenkt werden. Erfindungsgemäß ist der Zusatz von Tert-butyl-per-2-ethylhexanoat (TBPEH).

Die Erfindung wird durch die beigefügten Figuren und die folgenden Beispiele weiter erläutert.
Figur 1 zeigt die Zerfallskinetik von Peroxiden und Peroxidmischungen, gemessen mittels eines Differential-Thermoanalyse-Geräts.
Figur 2 zeigt die Messung der Beschleunigung der Vernetzungsgeschwindigkeit durch teilweisen Ersatz von TBPEHC durch TBPEH mithilfe eines Goettfert-ViscoElastographen.
Figur 3 zeigt Messungen mit reduzierter Gesamtperoxidmenge im Vergleich zur Standarddosierung von 1,5 % TBPEHC.

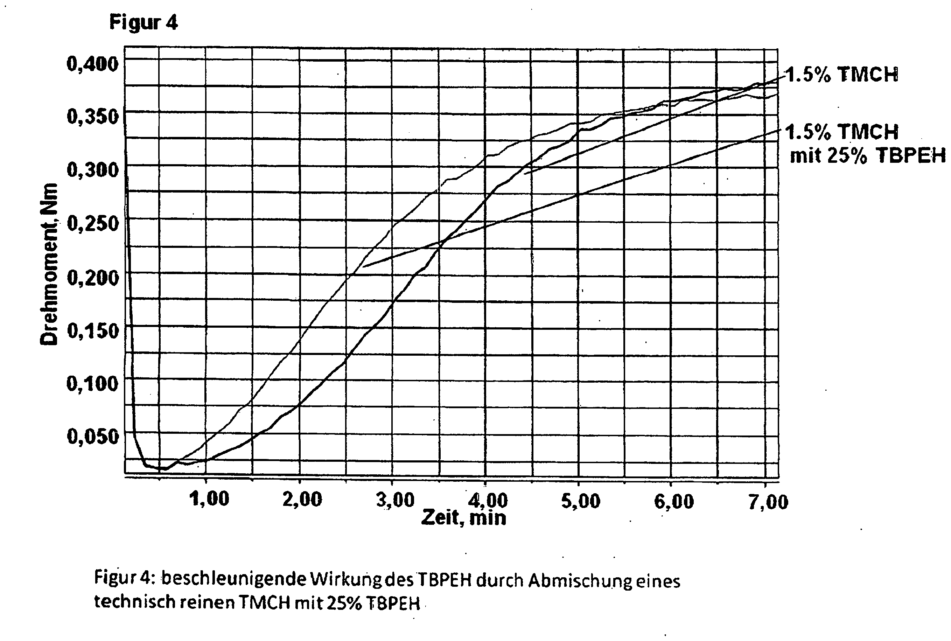

Figur 4 zeigt eine beschleunigende Wirkung des TBPEH durch Abmischung von technisch reinem TMCH mit 25 % TBPEH (nicht erfindungsgemäß).

### Beispiele

### Beispiel 1

Zur Entwicklung der vorliegenden Erfindung wurde für die Compoundherstellung ein 30D/25 mm-Einschneckenextruder der Firma Collin verwendet. Die Extrusionstemperatur der Vormischungen aus EVA/Peroxid (Abmischung im Mischgefäß 1ltr. über Kopf) betrug ca. 80 - 90 °C bei 60 Umdrehungen/min. Die Verweilzeit konnte so justiert werden dass keine Vorvernetzung eintritt bzw. der Gehalt an TBPEH so niedrig gewählt (15 % mit 85 % TBPEHC, bzw 25 % mit 75 % TMCH) dass noch keine Vorvernetzung eintritt. bzw. eine Erhöhung der Viskosität während des Extrusionsvorganges erkennbar wäre.

Der Extrusionsstrang wurde dann in einem Granulator zerkleinert. Das Granulat wurde in einem Rheometer des Types Goettfert-ViscoElastograph bei 130 °C vermessen und Vernetzungszeit und indirekt über den erzielten Drehmoment der erreichte Vernetzungsgrad ausgewertet.

Als Polymer wurde ein häufig verwendeter Einkapselungstyp der Firma Dupont Elvax PV1400 verwendet.

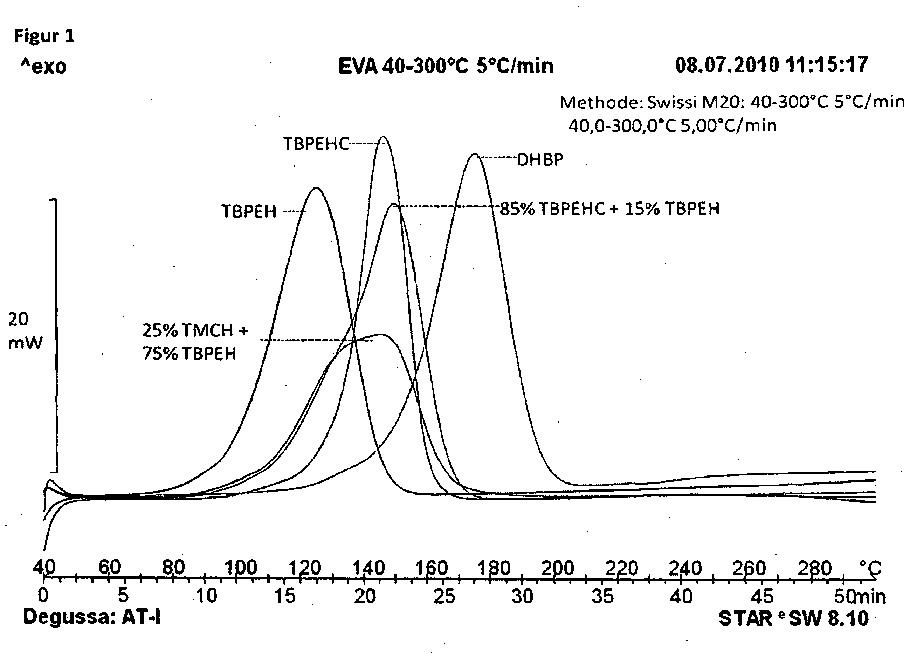

Zur zusätzlichen Überprüfung der Zerfallskinetik von beschleunigten Peroxidmischungen wurde ein Differential-Thermoanalyse-Gerät (DSC) der Firma Mettler verwendet. Die Ergebnisse sind in Figur 1 gezeigt.

Methode: Aufheizrate 5°C/min, Meßbereich 40-300°C, vergoldeter geschlossener Hochdrucktiegel

Die ermittelten Anspringtemperaturen liegen bei:
TBPEH ca. 60 °C
TBPEHC ca. 90 °C
85 % TBPEHC + 15 % TBPEH ca. 80 °C
75 % TMCH + 25 % TBPEH ca. 80 °C
DHBP ca. 90 °C

### Beispiel 2

Durch einen teilweisen Ersatz der 1,5 % Gesamtperoxiddosierung TBPEHC durch 0,1; 0,25 bzw. 0,5 % TBPEH konnte eine deutlich schnellere Vernetzungsreaktion sowie zusätzlich eine Steigerung der Vernetzungsdichte (Vernetzungsgrad) über den Drehmoment gemessen werden, wie in Figur 2 dargestellt.

### Beispiel 3

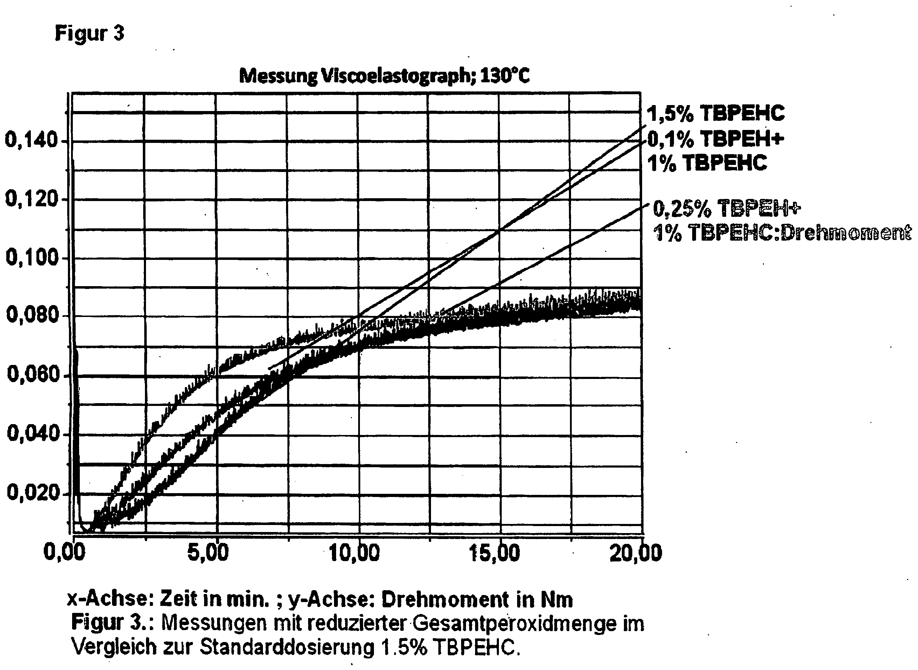

Erkennbar wird dass Peroxidkombinationen mit 1.1% Gesamtdosierung bestehend aus 1 % TBPEHC + 0.1% TBPEH die gleiche Wirksamkeit (Drehmoment) und Vernetzungsgeschwindigkeit aufweisen wie 1.5% TBPEHC. Insofern wird eine deutliches Einsparpotential an Peroxid möglich (0.4%) (siehe Figur 3).

Eine Kombination von 1 % TBPEHC und 0,25 % TBPEH erbringt zusätzlich eine schnellere Vernetzungsreaktion bei gleicher Wirksamkeit.

## Patentansprüche

1. Peroxidgemisch, umfassend eine Kombination von Tert-butyl-peroxy-2-ethylhexanoat (TBPEH) und Tert-butylperoxy(2-ethylhexyl)carbonat (TBPEHC), wobei TBPEH in einer Menge von 5 bis 15 Gew.-% und TBPEHC in einer Menge von 85 bis 95 Gew.-%, bezogen auf die Gesamtperoxidmischung, vorliegt.

2. Verwendung eines Peroxidgemisches nach Anspruch 1 zur Vernetzung von Polymeren.

3. Verwendung nach Anspruch 2 zur Vernetzung von Ethylenvinylacetat.

4. Verwendung nach Anspruch 2 oder 3 zur Vernetzung von Ethylenvinylacetatfolie bei der Einkapselung von Solarzellen-Wafern.

5. Verwendung nach einem der Ansprüche 2 bis 4,
**dadurch gekennzeichnet,**
**dass** die Vernetzung bei einer Temperatur im Bereich von 120 bis 150 °C erfolgt.

6. Verfahren zur Herstellung eines vernetzten Polymers, insbesondere eines Ethylenvinylacetats, umfassend
(i) Vermischen eines Peroxidgemisches nach Anspruch 1 mit einem vernetzbaren Polymer, insbesondere mit einem vernetzbaren Ethylenvinylacetat,
(ii) Formen des Gemisches aus vernetzbarem Polymer und Peroxiden und
(iii) Erhöhen der Temperatur des Gemisches, um eine Vernetzung des geformten Polymers zu bewirken.

7. Verfahren nach Anspruch 6,
**dadurch gekennzeichnet,**
**dass** das Peroxidgemisch als Masterbatch mit einem Gewichtsanteil von 0,5 Gew.-% bis 75 Gew.-% dem vernetzbaren Polymer, insbesondere einem vernetzbaren Ethylenvinylacetat zugegeben wird.

8. Verfahren nach Anspruch 6 oder 7,
**dadurch gekennzeichnet,**
**dass** Schritt (ii) in einer formgebenden Maschine, insbesondere in einer Folienextrusionsanlage durchgeführt wird.

9. Verfahren nach einem der Ansprüche 6 bis 8,
**dadurch gekennzeichnet,**
**dass** die Menge an zugegebenem Peroxidgemisch nach Anspruch 1, bezogen auf das Ethylenvinylacetat, 0,1 bis 5 Gew.-% beträgt.

10. Vormischung, umfassend
(a) ein Peroxidgemisch nach Anspruch 1, und
(b) ein vernetzbares Polymer, insbesondere ein Ethylenvinylacetat.

11. Vormischung nach Anspruch 10,
**dadurch gekennzeichnet,**
**dass** sie in Granulat- oder/und Pulverform vorliegt.

12. Vormischung nach Anspruch 10 oder 11 als Masterbatch,
**dadurch gekennzeichnet,**
**dass** der Gehalt an Peroxiden 0,5 Gew.-% bis 75 Gew.-%, bezogen auf das Gesamtgewicht der Vormischung, beträgt.

## Claims

1. Peroxidmixture, comprising a combination of tert-butylperoxy-2-ethylhexanoat (TBPEH) and tert-butylperoxy(2-ethylhexyl)carbonat (TBPEHC), wherein TBPEH is present in an amount of 5 to 15 wt.% and TBPEHC is present in an amount of 85 to 95 wt.%, based on the total peroxide mixture.

2. Use of a peroxid mixture according claim 1 for crosslinking polymers.

3. Use according to claim 2 for crosslinking ethylene vinyl acetate.

4. Use according to claim 2 or 3 for crosslinking of ethylene vinyl acetate film in the encapsulation of solar cell wafers.

5. Use according to any one of claims 2 to 4,
**characterized in that**
the crosslinking takes place at a temperature in the range of from 120 to 150 °C.

6. Process for the production of a crosslinked Polymer, in particular of an ethylene vinyl acetate, comprising
(i) mixing a peroxid mixture according claim 1 with a crosslinkable polymer, in particular with a crosslikable ethylene vinyl acetate,
(ii) shaping the mixture of a crosslinkable polymer and peroxides, and
(iii) increasing the temperature of the mixture in order to bring about crosslinking of the shaped polymer.

7. Process according to claim 6,
**characterised in that**
the peroxide mixture is added in the form of a masterbatch in an amount by weight of from 0,5 wt.% to 75 wt.% to the crosslinkable polymer, in particular to a crosslinkable ethylene vinyl acetate.

8. Process according to claim 6 or 7,
**characterised in that**
step (ii) is carried out in a shaping machine, in particular in a film extrusion system.

9. Process according to any one of claims 6 to 8,
charaterised in that
the amount of added peroxide mixture according claim 1, based on the ethylene vinyl acetate, is from 0,1 to 5 wt.%.

10. Premixture, comprising
(a) a peroxide mixture according to claim 1, and
(b) a crosslinkable polymer, in particular an ethylene vinyl acetate.

11. Premixture according to claim 10,
**characterised in that**
it is present in granulate or/and powder form.

12. Premixture according to claim 10 or 11 in the of a materbatch,
**characterised in that**
the content of peroxids is from 0,5 wt.% to 75 wt.%, based on the total weigt of the premixture.

## Revendications

1. Mélange de peroxydes comprenant une association de tert-butyl-peroxy-2-éthylhexanoate (TBPEH) et de tert-butylperoxy(2-éthyl-hexyl)carbonate (TBPEHC), dans lequel le TBPEH est présent dans une proportion de 5 à 15 % en poids et le TBPEHC est présent dans une proportion de 85 à 95 % en poids par rapport à la totalité du mélange de peroxydes.

2. Utilisation d'un mélange de peroxydes selon la revendication 1 pour la réticulation de polymères.

3. Utilisation selon la revendication 2 pour la réticulation d'éthylène-acétate de vinyle.

4. Utilisation selon la revendication 2 ou 3 pour la réticulation de feuilles d'éthylène-acétate de vinyle pour l'encapsulement de plaquettes de silicium de cellules solaires.

5. Utilisation selon l'une des revendications 2 à 4,
**caractérisée en ce**
**que** la réticulation se déroule à une température comprise dans l'intervalle de 120 à 150 °C.

6. Procédé de fabrication d'un polymère réticulé, en particulier d'un éthylène-acétate de vinyle, comprenant
(i) le mélange d'un mélange de peroxydes selon la revendication 1 avec un polymère réticulable, en particulier avec un éthylène-acétate de vinyle réticulable,
(ii) le moulage du mélange du polymère réticulable et des peroxydes et
(iii) l'augmentation de la température du mélange, afin d'induire la réticulation du polymère moulé.

7. Procédé selon la revendication 6,
**caractérisé en ce**
**que** le mélange de peroxydes est ajouté, en tant que mélange maître dans une proportion en poids de 0,5 à 75 % en poids, au polymère réticulable, en particulier à un éthylène-acétate de vinyle réticulable.

8. Procédé selon la revendication 6 ou 7,
**caractérisé en ce**
**que** l'étape (ii) est réalisée dans une machine de façonnage, en particulier dans une installation d'extrusion de feuilles.

9. Procédé selon l'une des revendications 6 à 8,
**caractérisé en ce**
**que** la proportion ajoutée de mélange de peroxydes selon la revendication 1 atteint 0,1 à 5 % en poids par rapport à l'éthylène-acétate de vinyle.

10. Prémélange comprenant
(a) un mélange de peroxydes selon la revendication 1 et
(b) un polymère réticulable, en particulier un éthylène-acétate de vinyle.

11. Prémélange selon la revendication 10
**caractérisé en ce**
**qu'**il est présent sous forme de granulé et/ou de poudre.

12. Prémélange selon la revendication 10 ou 11, en tant que mélange maître,
**caractérisé en ce**
**que** le contenu en peroxydes atteint 0,5 à 75 % en poids par rapport au poids total du prémélange.
